# EUROPEAN PATENT APPLICATION

(11) **EP 1 207 534 A1**
(43) Date of publication of application: **22.05.2002**
(21) Application number: 00403221.5
(22) Date of filing: 17.11.2000
(51) Int. Cl.: G11C 16/12

(54) **Integrated circuit eeprom memory and method of programming the same**

(71) Applicant: MOTOROLA, INC., Schaumburg, IL 60196 (US)
(72) Inventor: Carman, Eric Scott, 01710 Thoiry (FR); Hemon, Erwan, 31500 Toulouse (FR); Raguet, Philippe, 31600 Seysses (FR)
(74) Representative: Gibson, Sarah Jane

(57) **Abstract**

An integrated circuit EEPROM memory array (5) of thick oxide, single poly EEPROM memory cells (10, 20, 30, etc...) has switching circuitry on memory cell source electrodes (14, 24) to reduce the voltage levels that must be switched when programming the array (5). The cells (10, 20, 30, etc...) are also provided with circuitry on the drain electrodes (16, 26) to block voltages. In this way the die area of the integrated circuit may be significantly reduced, resulting in reduced die cost, improved reliability, and improved production yields.

## Description

### Field of the Invention

This invention relates to integrated circuit EEPROM memories, and particularly but not exclusively to such memories having thick gate oxide, single polysilicon (poly) layer structures.

### Background of the Invention

For programming and erasing a thick gate oxide single poly EEPROM, the problem lies in efficiently switching very high voltages. High voltages are required for Fowler-Nordheim tunnelling of electrons across such thick oxides.

It is known in circuit solutions for single poly EEPROMs to have programming controlled by switching voltages to the EEPROM control gate (e.g., U.S. Patent Number 5,301,150, entitled "Flash erasable single poly EPROM device", uses control gate voltage for bit select and hot electron programming).

It is also known for transistors with high breakdown voltages to be used to switch the EEPROM control gate, but incorporation of such high breakdown voltage transistors increases die surface area.

It is also known (e.g., from U.S. Patent Number 5,504,706, entitled "Low Voltage Fowler-Nordheim Flash EEPROM memory array utilizing single level poly cells") for an isolation structure to be used which makes possible positive and negative voltages on a control capacitor.

These known approaches, although functional, all use circuit design techniques that result in larger die area. It is common knowledge in the memory design community that the die area of control circuitry, especially for small memory arrays is a significant problem. These known approaches switch the highest voltage required for EEPROM programming directly to control gates of EEPROM cells to select which cells in the EEPROM array are programmed or not, requiring use of circuit design techniques which result in larger die area.

It is an object of the present invention to provide an integrated circuit EEPROM memory wherein the above mentioned disadvantages may be alleviated.

### Statement of Invention

In accordance with a first aspect of the present invention there is provided an integrated circuit EEPROM memory as claimed in claim 1.

In accordance with a second aspect of the present invention there is provided a method of programming an integrated circuit EEPROM memory as claimed in claim 9.

### Brief Description of the Drawings

One integrated circuit EEPROM memory incorporating the present invention will now be described, by way of example only, with reference to the accompanying drawings, in which:
FIG. 1 shows a schematic circuit diagram of part of an EEPROM cell array in a single poly EEPROM memory, illustrating programming voltages applied to the array.
FIG. 2 shows a schematic circuit diagram of circuitry connected to source electrodes of the EEPROM cells of the array of FIG. 1, illustrating voltages applied thereto during programming.
FIG. 3 shows a schematic circuit diagram of circuitry connected to drain electrodes of the EEPROM cells of the array of FIG. 1, illustrating voltages applied thereto to block drain voltages from low voltage circuitry during programming.
FIG. 4 shows a cross-sectional view of an integrated circuit implementation of the drain circuitry of FIG. 3.

### Description of Preferred Embodiment(s)

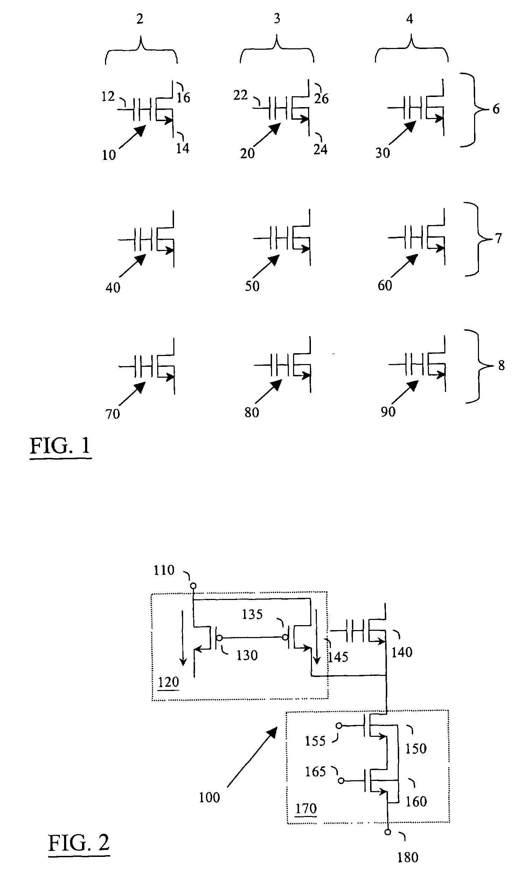

Referring to FIG. 1, there is shown an EEPROM (Electrically Erasable Programmable Read Only Memory) cell array 5 forming part of a thick oxide, single poly EEPROM memory integrated circuit. The array 5 has three bit columns: 2, 3 and 4 respectively which correspond to data bits; and three word rows: 6, 7 and 8 respectively which correspond to data words made up of one bit from each column. Nine memory cells 10, 20, 30, 40, 50, 60, 70, 80 and 90 of the array are shown, each having gate electrodes (12, 22, etc...), source electrodes (14, 24, etc...), and drain electrodes (16, 26, etc...). Each memory cell is addressed by its column and row position. For example, the first memory cell 10 is in column 2 and row 6, therefore the first memory cell 10 is addressed by selecting column 2, row 6 and corresponds to the second bit of the first word in the array 5.

In operation, the array 5 may be written to (programmed), read from or 'flash' erased (all memory cells erased).

In order to program a cell or a number of cells, a high voltage, VP, (typically 45V) is applied to the gate electrodes 12, 22, etc... of all the memory cells of the EEPROM array 5, including the nine cells 10, 20, 30, 40, 50, 60, 70, 80 and 90 shown in FIG. 1. VP may be provided by an external source via a pad (not shown) or by a conventional charge pump of the integrated circuit (not shown).

By way of example, it is desired to program cell 20 (row 6, column 3) and not to program cell 10 (row 6, column 2). The source electrode 14 of cell 10 is held at voltage VSI (typically 30V). Therefore there is a voltage of approximately 15V between the gate electrode 12 and the source electrode 14. This is not sufficient to cause significant Fowler-Nordheim tunnelling in the thick oxide and therefore the first memory cell 10 is not programmed.

The source electrode 24 of the second EEPROM cell 20 is held at VSP (typically 0V). Therefore there is a voltage of approximately 45V between the gate electrode 22 and the source electrode 24, which is sufficient to cause significant Fowler-Nordheim tunnelling and therefore the second memory cell 20 is programmed.

It will be appreciated that for each unselected memory cell, the voltage VSI (30V) is applied to the source electrode, and the body and the drain electrode (to be further described below) substantially reduces the potential for program disturb of the unselected cells, and eliminates parasitic leakage to unselected bits.

Referring now also to FIG. 2 there is shown EEPROM source electrode circuitry 100 which selectively switches the source electrode of a memory cell 140 between voltages VSP and VSI. The memory cell 140 represents each of the memory cells of FIG. 1. A pair of PMOS transistors 130 and 135 have their gate electrodes coupled together to form a current source 120. A voltage source 110 is coupled to the drain electrodes of the PMOS transistors 130 and 135. In this way a current 145 is provided by the current source 120.

First and second NMOS transistors 150 and 160 respectively are arranged as a cascode 170. The gate electrode of the first NMOS transistor 150 is coupled to a voltage 155 of 13V. The drain electrode of the first NMOS transistor 150 is coupled to receive the current 145 from the current source 120, and is also coupled to the source electrode of the memory cell 140. The second NMOS transistor 160 has a drain electrode coupled to the source electrode of the first NMOS transistor 150, a source electrode coupled to a word select node 180, and a gate electrode coupled to a bit line control node 165, which in turn is coupled to logic level control circuitry.

Depending on the voltage of the bit-line control node 165, the cascode 170 either sinks current from the current source 120 to the word select node 180, or the first NMOS 150 drain electrode is charged to voltage VSI. In this way, when the voltage on the Bit Line Control node 165 is 0V, the current 145 from the current source 120 charges the source electrode voltage of the memory cell 140 to VSI, such that the memory cell 140 will not be programmed. Conversely, when the voltage of the Bit Line Control node 165 is at VDD (5V), then the cascode 170 sinks the current 145 to the word select node 180, which is at VSP (0V), and the source electrode voltage of the memory cell 140 is held at VSP, such that the memory cell 140 will be programmed.

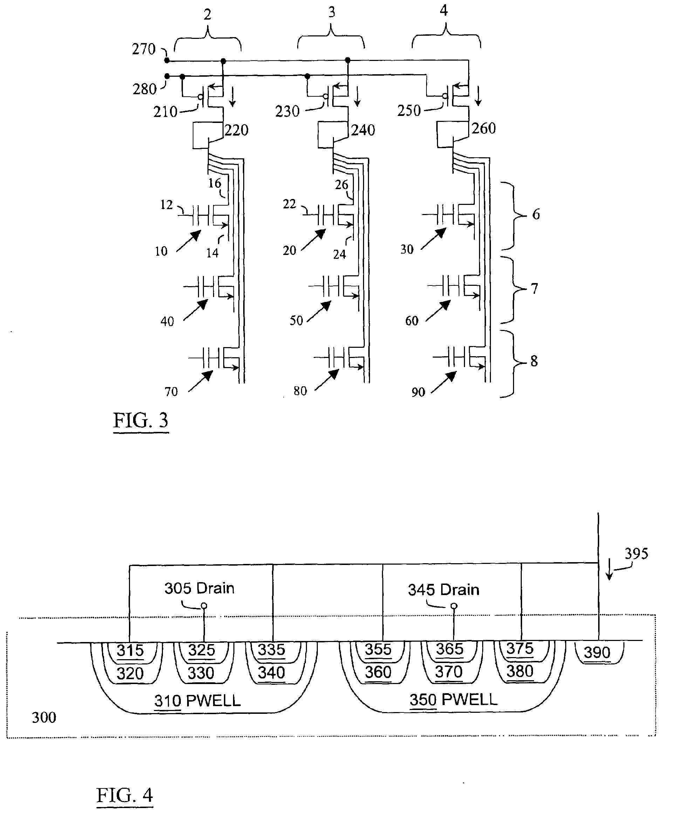

Referring now also to FIG. 3, there is shown memory cell drain electrode circuitry 200 which protects logic level output circuitry (not shown) from switching voltages applied to the source electrodes of the memory cells of array 5. The reference numbers common to FIGs. 1 and 3 refer to common elements in those FIGs.

First, second and third current transistors 210, 230 and 250 respectively of the circuitry 200 each have source electrodes coupled to a voltage source node 270 and gate electrodes coupled to a source bias node 280.

First, second and third NPN transistors 220, 240 and 260 respectively each have base and collector electrodes coupled to the drain electrodes of the first, second and third current transistors 210, 230 and 250 respectively. In this way the collector electrodes of the first, second and third NPN transistors 220, 240 and 260 respectively are commonly coupled to the voltage source node 270 via the first, second and third current transistors 210, 230 and 250 respectively.

Each of the first, second and third NPN transistors 220, 240 and 260 respectively have multiple emitter electrodes coupled to each of the drain electrodes of the memory cells in their respective bit columns. Therefore the first NPN transistor 220, which corresponds to the first bit column 2, has an emitter electrode coupled to the drain electrode 16 of the memory cell 10, and further emitter electrodes coupled to the drain electrodes of memory cells 40 and 70. The second and third NPN transistors 240 and 260 are arranged similarly with multiple emitter electrodes, each emitter electrode being coupled to a drain electrode of a memory cell in the respective bit column.

The die area of the drain electrode circuitry 200 is minimized by using the first, second and third NPN transistors 220, 240 and 260 respectively, due to their multiple emitters and common collectors.

It will be understood that the control line voltage VP applied to the gate electrodes of the memory cells is 44.3V or up to 50V if using an external source on a probe pad (not shown). It will be further appreciated that during programming the drain electrodes of the programmed bits (in the present example the drain electrode 26 of the memory cell 20) will be at a voltage VDP, which is substantially VSP (0V), whereas the drain electrodes of unprogrammed bits (such as the drain electrode 16 of the memory cell 10) will be at VDI, which is VSI-V_{BE}.

Referring now also to FIG. 4 there is shown a cross section of the first, second and third NPN transistors 220, 240 and 260 respectively of FIG. 3. A single common epitaxial layer 300 is used to form the common collector.

A first PWELL 310, of p- material is formed in the layer 300, having an emitter 305. A first p region 320 is formed in the PWELL 310, having a first p+ region 315 enclosed in the first p region 320. A first n region 330 is also formed in the PWELL 310, having a first n+ region 325 enclosed in the first n region 320. A second p region 340 is also formed in the PWELL 310, having a second p+ region 335 enclosed in the second p region 340.

Similarly a second PWELL 350 of p- material is formed in the layer 300, having an emitter 345 and having first and second p regions 360 and 380 respectively, and a first n region 370, each with respective p+ and n+ regions 355, 375 and 365 respectively, in a manner similar to those of the first PWELL 310.

A further n+ region 390 is also formed in the layer 300. Current 395 is supplied to this n+ region, and to the p+ regions 315, 335, 355 and 375 respectively. It will be appreciated that die area is significantly reduced by using the single common epitaxial layer 300 in this way.

Considering now the erase and read operations in relation to the array 5, in order to erase the entire array 5 a voltage VE (typically -45V, provided externally at a pad - not shown), is applied to the gate electrodes of all memory cells in the array 5. The source electrodes of the memory cells are grounded so that all cells are 'flash' (or bulk) erased at the same time.

For a read operation the gate electrode voltage of all the memory cells is set to VR (typically 4.3V) and the source electrodes of those memory cells in word rows (7 and 8) other than the selected word row 6 are biased at VR. Only the memory cells 10, 20 and 30 (those in the selected word row 6) can conduct current.

It will be appreciated that in the memory array 5 the memory cells are formed by NMOS transistors in a way that is quite different from typical NMOS operation. The program inhibit voltage of substantially 30 volts is applied to the source and body electrodes, which are short-circuited, but in order to inhibit programming the voltage must also be applied to the drain electrodes. The body electrode of an NMOS transistor forms the well (p-) in which the source and drain regions are formed, such as the first and second PWELLs 310 and 350 of FIG. 4.

In the array 5 the forward biasing of the diode formed between NMOS body and drain (namely between the PWELL 310 (p- region) and the n+ drain region 335) is relied on for the drain voltage, whereas in typical operation the diode formed between NMOS body and drain is never forward biased.

It will further be appreciated that the program inhibit voltage on the EEPROM drain must be blocked from reaching the output circuitry. The above memory array 5 uses NPN transistors connected as diodes to block the program inhibit voltage from the low voltage circuitry, whereas known EEPROM technologies do not have NPN transistors or diodes that can be used for voltage blocking.

Furthermore, in the above array 5 a technology of PWELL in N-EPI on P-Substrate is used to form the EEPROM (and MOS transistor) body implant. For this reason the PWELL is isolated from the P-Substrate and can be biased. Typically EEPROM technologies do not have isolated PWELLs, so the EEPROM body cannot be biased positively.

In conclusion, it will be understood that the integrated circuit EEPROM memory, by employing bit selection using source switching as described above, provides the advantage of a significant reduction (possibly by approximately 80%) in the die area of the memory circuit as compared to control gate switching, and that the source switching technique also applies to large memory arrays. It will be appreciated that such reduced memory circuit area results in reduced die cost, improved reliability, and improved production yields.

It will be appreciated that alternative embodiments to the one described above are possible. For example, using different silicon technologies, arrangements similar to that described above are possible, but with different voltage levels and different circuit configurations. Similarly the details of the array and the precise arrangements of the transistors may also differ. For example MOS transistors could be used in place of the NPN blocking transistors. If arranged in a cascode as in the source select circuitry the die area required is similar to that for NPN blocking transistors.

Furthermore the cascode transistors for the source select circuitry (and for the drain blocking circuitry) could be replaced by individual high voltage transistors.

## Claims

1. An integrated circuit EEPROM memory (5), comprising:
a plurality of memory cells (10, 20, 30) each formed by a transistor having a source electrode (14, 24), a gate electrode (12, 22) and a drain electrode(16, 26);
biasing circuitry arranged to provide a positive bias voltage to the gate electrodes of each of the plurality of memory cells; and,
switching circuitry (100) coupled to selectively switch each of the source electrodes of the plurality of memory cells,
wherein during a programming operation, selected memory cells of the plurality of memory cells are programmed by applying the positive bias voltage to the gate electrodes of each of the plurality of memory cells and by switching the source electrodes of the selected memory cells.

2. The integrated circuit EEPROM memory according to claim 1, wherein the switching circuitry (100) includes at least two transistors (150, 160) in a cascode arrangement (170).

3. The integrated circuit EEPROM memory according to claim 2, wherein the at least two transistors (150, 160) are NMOS transistors.

4. The integrated circuit EEPROM memory according to any preceding claim, further comprising blocking circuitry (210, 220, 230, 240) coupled to each of the drain electrodes of the plurality of memory cells in order to block unwanted leakage voltages at the drain electrodes of unselected memory cells during the programming operation.

5. The integrated circuit EEPROM memory according to claim 4 wherein the blocking circuitry comprises a plurality of transistors (220, 240) formed on a single epitaxial layer and having a common collector electrode.

6. The integrated circuit EEPROM memory according to claim 5 wherein the plurality of transistors (220, 240) each have multiple emitter electrodes coupled to respective drain electrodes of the plurality of memory cells.

7. The integrated circuit EEPROM memory according to any preceding claim wherein during an erase operation, a negative voltage (V_{c}) is applied to the gate electrode of each memory cell, such that the memory is bulk erased.

8. The integrated circuit EEPROM memory according to any preceding claim formed with a thick gate oxide single polysilicon structure, in which each source electrode of each memory cell is short-circuit coupled to a body electrode of the memory cell.

9. A method of programming an integrated circuit EEPROM memory, the memory (5) comprising a plurality of memory cells (10, 20, 30) each formed by a transistor having a source electrode (14, 24), a gate electrode (12,22) and a drain electrode (16,26) ;
the method comprising the steps of:
biasing the gate electrodes of each of the plurality of memory cells with a positive bias voltage; and,
selectively switching each of the source electrodes of the plurality of memory cells,
wherein selected memory cells of the plurality of memory cells having switched source electrodes are programmed.

10. The method according to claim 9 wherein the integrated circuit EEPROM memory has a thick gate oxide single polysilicon structure.
